(19) Europäisches Patentamt
European Patent Office
Office européen des brevets

(11) EP 2 911 163 A1

(12) DEMANDE DE BREVET EUROPEEN

(43) Date de publication:
26.08.2015 Bulletin 2015/35

(51) Int Cl.:
*H01B 11/10* (2006.01)   *H01B 11/18* (2006.01)
*H05K 9/00* (2006.01)

(21) Numéro de dépôt: 15154744.5

(22) Date de dépôt: 11.02.2015

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME

(30) Priorité: 21.02.2014 FR 1451383

(71) Demandeur: Nexans
75008 Paris (FR)

(72) Inventeurs:
• Morice, Stéphane
  62790 LEFOREST (FR)
• Grendana, Soizik
  08170 FUMAY (FR)
• Sage, Jean-Jacques
  26790 SUZE-LA-ROUSSE (FR)

(74) Mandataire: Allain, Laurent et al
Ipsilon Feray Lenne Conseil
63, avenue du Général Leclerc
92340 Bourg-la-Reine (FR)

(54) **Blindage électromagnétique tressé pour câbles**

(57) L'invention se rapporte à un blindage électro-magnétique de câble, comprenant une tresse (1) constituée d'une pluralité de fils (2) en contact les uns avec les autres.

La principale caractéristique d'un blindage selon l'invention est qu'au moins un fil (2) possède une section transversale ovale.

Fig. 1

**Description**

L'invention se rapporte à un blindage électromagnétique tressé pour câbles, et en particulier pour câbles électriques.

De façon générale, un blindage électromagnétique sert à réduire le champ électromagnétique au voisinage d'un objet en interposant une barrière entre la source du champ et l'objet à protéger. Cette barrière doit être réalisée avec un matériau conducteur électrique. Dans le cadre d'un câble électrique, ce blindage prend souvent la forme d'une tresse métallique, placée étroitement autour dudit câble.

Les tresses métalliques existantes, servant de blindages électromagnétiques à ces câbles, impliquent dans la majorité des cas, des fils de section circulaire, positionnés les uns à coté des autres. Une tresse composée de fils de section circulaire, permet ainsi d'assurer de la souplesse et de la flexibilité au câble, sans endommager le blindage. Or, de telles tresses présentent l'inconvénient de mettre en oeuvre un grand nombre de fils, entrainant un surplus de matière première et un temps de fabrication plus important, et donc des surcoûts élevés.

Une tresse selon l'invention, qui est conçue pour assurer un blindage électromagnétique d'un câble, permet de s'affranchir des inconvénients relevés dans l'état de la technique.

L'invention a pour objet un blindage électromagnétique de câble, comprenant une tresse constituée d'une pluralité de fils en contact les uns avec les autres.

La principale caractéristique d'un blindage selon l'invention, est qu'au moins un fil possède une section transversale ovale. Ainsi, puisque chaque fil de section transversale ovale est amené à venir au contact de la surface externe du câble au niveau du grand coté de ladite section, la tresse nécessite donc moins de fils pour recouvrir entièrement ledit câble, par rapport à une configuration où elle ne serait composée que de fils de section transversale circulaire. Il en résulte une consommation réduite de matière première pour élaborer ces fils, donc une baisse du temps de fabrication de la tresse, et donc une réduction des coûts de fabrication. Avec des fils de section transversale ovale, la tresse permet d'assurer une bonne souplesse et une bonne flexibilité du câble. Le câble peut par exemple être de type électrique, optique ou électronique. La tresse peut ainsi être constituée, soit partiellement, soit intégralement, de fils de section transversale ovale.

Préférentiellement, chaque fil de la tresse possède une section transversale ovale. Selon cette configuration, tous les fils de la tresse ont une section transversale ovale.

Avantageusement, le rapport entre la longueur du petit coté « a » de la section transversale ovale de chaque fil et la longueur du grand coté « b » de ladite section, est compris entre 45% et 90%. Un tel rapport traduit le fait que chaque fil ne doit pas posséder un profil trop écrasé, qui pourrait compromettre la flexibilité et la souplesse du câble. De plus, avec des fils possédant une telle section transversale ovale, la tresse permet de conserver une bonne tenue mécanique.

De façon préférentielle, ledit rapport est compris entre 60 et 70%. Il s'agit d'un rapport optimisé permettant à la tresse d'avoir une bonne tenue mécanique et de garantir au câble une flexibilité et une souplesse satisfaisante.

Préférentiellement, les fils ont des sections transversales ovales de tailles différentes.

De façon avantageuse, les fils ont des sections transversales ovales de formes différentes.

Avantageusement, la tresse est en métal.

De façon préférentielle, la tresse est réalisée dans un matériau à choisir parmi du cuivre, de l'aluminium et de l'acier.

Préférentiellement, la tresse possède au moins deux couches concentriques de fils de section transversale ovale.

De façon avantageuse, tous les fils de la tresse ont une section transversale ovale, lesdits fils étant disposés en spirale. De cette manière, la tresse possède une géométrie en spirales. Par rapport à une tresse possédant des fils torsadés, une tresse possédant des fils en spirales a un diamètre qui est réduit de 5% à 10%, et préférentiellement de 6% à 8%. De cette manière, grâce à cette réduction de diamètre, un ensemble formé par un câble et une tresse est plus flexible.

Selon un autre mode de réalisation d'un blindage électromagnétique selon l'invention, tous les fils de la tresse ont une section transversale ovale, lesdits fils étant torsadés entre eux.

L'invention a pour deuxième objet un ensemble comprenant au moins un câble et un blindage électromagnétique conforme à l'invention.

La principale caractéristique d'un ensemble selon l'invention est que la tresse entoure ledit au moins un câble en étant à son contact.

Avantageusement, un ensemble selon l'invention comprend au moins un câble électrique.

Un blindage électromagnétique de câble selon l'invention présente l'avantage d'être facile et rapide à fabriquer, dans la mesure où la tresse est constituée d'un nombre réduit de fils par rapport à une tresse existante, constituée de fils de section transversale circulaire. Il a de plus l'avantage d'être d'un coût réduit par rapport à celui d'un blindage existant, en raison d'une réduction du temps de fabrication et d'une baisse de la quantité de matière première impliquée.

EP 2 911 163 A1

On donne, ci-après, une description détaillée d'un mode de réalisation préféré d'un blindage électromagnétique selon l'invention et d'un ensemble câble/blindage selon l'invention, en se référant aux figures 1 à 4B.

- La figure 1 est une vue schématique en coupe transversale d'un ensemble selon l'invention, comprenant un câble et un blindage électromagnétique selon l'invention,

- La figure 2 est une vue schématique en coupe transversale d'un fil d'une tresse d'un blindage électromagnétique selon l'invention,

- Les figures 3A, 3B, 3C sont trois vues schématiques en coupe transversale de trois fils consécutifs d'une tresse d'un blindage selon l'invention, respectivement à un stade sans contrainte, à un stade intermédiaire de positionnement autour d'un câble et à un stade de positionnement final autour dudit câble,

- Les figures 4A et 4B sont deux vues schématiques en coupe transversale d'un exemple de trois fils consécutifs d'une tresse d'un blindage mal dimensionnée, respectivement à un stade de positionnement sans contrainte et à un stade de positionnement final autour dudit câble.

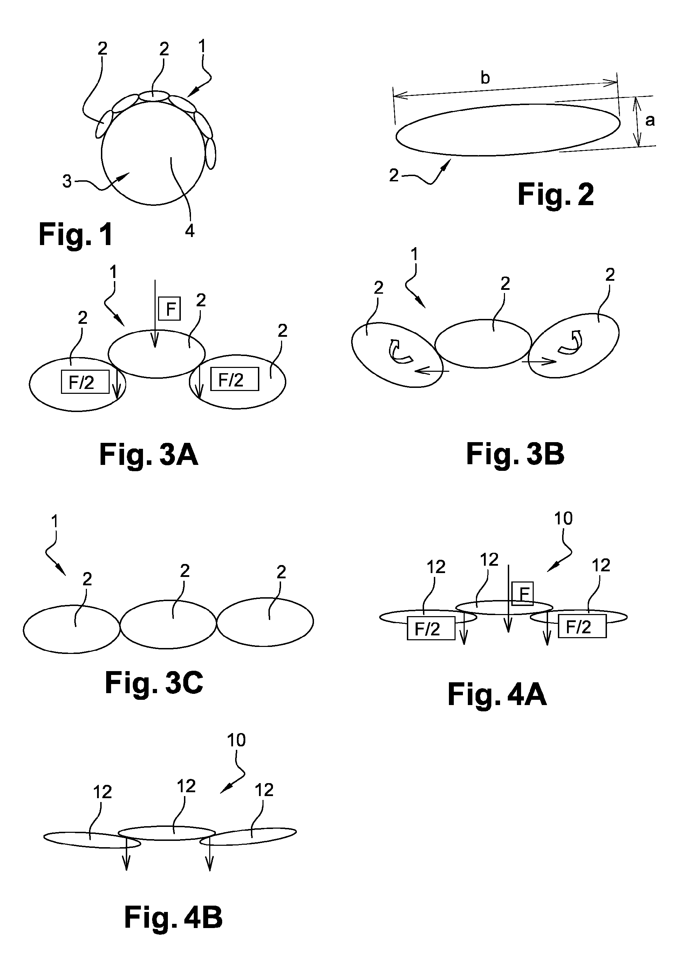

En se référant à la figure 1, un blindage électromagnétique selon l'invention, comprend une tresse 1 constituée par une pluralité de fils métalliques 2 de section transversale ovale. Cette tresse 1 est placé autour d'un câble électrique 3 comprenant au moins un conducteur électrique 4, pouvant ou non être entouré par une gaine isolante. Chaque conducteur électrique 4 comporte un ou plusieurs fils métalliques, pouvant, par exemple, être en cuivre. De façon générale, il est important de souligner que pour assurer un blindage électromagnétique efficace, il faut que la tresse 1 recouvre le plus possible la surface extérieure du câble 3. Autrement dit, le taux de recouvrement de la tresse 1 sur le câble 3 doit être maximal.

En se référant à la figure 2, chaque fil métallique constituant la tresse 1 possède une section transversale ovale caractérisée par un petit coté « a » et un grand coté « b ». Il a été observé que pour obtenir une tresse 1 performante, tant sur le plan fonctionnel que structurel, il faut que le rapport de la longueur du petit coté « a » sur la longueur du grand coté « b » soit compris entre 45% et 90%. Autrement dit, il faut que :

$$0.45 \leq a/b \leq 0.9$$

Préférentiellement, il a été observé que pour que cette tresse 1 ait une efficacité optimale, il faut que :

$$0.6 \leq a/b \leq 0.7$$

Ainsi, avec un tel dimensionnement de ses fils 2, la tresse 1 remplit efficacement sa fonction de blindage électromagnétique vis-à-vis du câble 3, tout en garantissant une bonne flexibilité et une bonne souplesse dudit câble. De plus, avec de tels fils, la tresse possède une bonne tenue mécanique.

Le tableau ci-après établit une comparaison entre différents types de tresse, entourant un câble de diamètre constant.

Tableau 1: comparaison du nombre de fils et du gain de matière obtenus avec différents types de tresses entourant un câble ayant un diamètre de 5mm.

| Exemple | cercle | ovale a/b=0,13/0,16 | ovale 0,12/0,18 | ovale 0,11/0,20 | ovale 0,10/0,22 |
|---|---|---|---|---|---|
| diamètre du câble (mm) | 5 | 5 | 5 | 5 | 5 |
| diamètre de chaque fil de la tresse (mm) | 0,14 | 0,13-0,15 | 0,12-0,16 | 0,11-0,18 | 0,1-0,2 |
| Nombre de fils | 118 | 110 | 103 | 91 | 82 |
| Gain de matière en % | | 7% | 15% | 22% | 30% |

Il ressort de ce tableau que plus les fils de la tresse sont aplatis (c'est-à-dire plus le rapport a/b diminue) plus le gain de matière est important, car moins de fils sont nécessaires à la constitution de la tresse 1. En vertu de cet avantage, il serait donc tentant de choisir des fils 2 de tresse 1 les plus aplatis possible.

Or, en se référant aux figures 4A et 4B, si les fils 12 de la tresse 10 sont trop aplatis, il devient difficile, voire impossible, d'obtenir un taux de recouvrement optimal du câble 3 par la tresse 10. En effet, en se référant à la figure 4A, en appliquant schématiquement une force F sur un tel premier fil 10 de tresse, ce premier fil 10 transmet alors une force F/2 sur les deux fils 12 adjacents avec lesquels il est au contact.

En se référant à la figure 4B, ces deux fils 12 n'ont pas la place de s'écarter pour permettre audit premier fil 12 de venir au contact du câble 3. Par conséquent, avec des fils 12 trop écrasés, le taux de recouvrement de la tresse 10 sur le câble 3 est médiocre. De plus, cette tresse 10 sous tension mécanique, ne garantit plus d'obtenir une bonne flexibilité et une bonne souplesse du câble 3.

Il est donc fondamental que chaque fil 2 de la tresse 1 possède une section transversale ovale, respectant certaines limites en matière de dimensionnement.

Ainsi, avec des fils 2 ayant une section transversale ovale respectant un rapport a/b compris entre 45% et 90%, le taux de recouvrement de la tresse 1 sur le câble 3 peut être optimisé.

En effet, en se référant à la figure 3A, en appliquant schématiquement une force F sur un tel premier fil 2 de tresse, ce fil transmet alors une force F/2 sur les deux fils 2 adjacents avec lesquels il est au contact.

En se référant à la figure 3B, ces deux fils 2 réagissent à cette force F/2 en s'écartant l'un de l'autre pour laisser passer le premier fil 2.

En se référant à la figure 3C, le premier fil 2 et les deux fils adjacents 2 finissent par se retrouver parfaitement alignés, pour assurer un recouvrement optimisé du câble 3.

De façon à accroître les propriétés de la tresse 1 en fonction des caractéristiques du câble 3 qu'elle protège, les fils 2 constitutifs de ladite tresse 1 peuvent avoir des sections transversales ovales de tailles différentes et/ou de formes différentes, et être réalisés dans des métaux différents.

Par conséquent, pour qu'une tresse 1 selon l'invention soit parfaitement efficace en tant que blindage électromagnétique, tout en permettant une bonne flexibilité et une bonne souplesse du câble 3, la section transversale ovale de chaque fil 2 constituant ladite tresse 1, doit respecter certaines proportions.

**Revendications**

1.  Blindage électromagnétique de câble, comprenant une tresse (1) constituée d'une pluralité de fils (2) en contact les uns avec les autres, **caractérisé en ce qu'**au moins un fil (2) possède une section transversale ovale.

2.  Blindage électromagnétique selon la revendication 1, **caractérisé en ce que** chaque fil (2) de la tresse (1) possède une section transversale ovale.

3.  Blindage électromagnétique selon la revendication 2, **caractérisé en ce que** le rapport entre la longueur du petit coté (a) de la section transversale ovale de chaque fil (2) et la longueur du grand coté (b) de ladite section, est compris entre 45% et 90%.

4.  Blindage électromagnétique selon la revendication 3, **caractérisé en ce que** ledit rapport est compris entre 60 et 70%.

5.  Blindage électromagnétique selon l'une quelconque des revendications 2 à 4, **caractérisé en ce que** les fils (2) ont des sections transversales ovales de tailles différentes.

6.  Blindage électromagnétique selon l'une quelconque des revendications 2 à 5, **caractérisé en ce que** les fils (2) ont des sections transversales ovales de formes différentes.

7.  Blindage électromagnétique selon l'une des revendications 2 à 6, **caractérisé en ce que** la tresse (1) est réalisée dans un matériau à choisir parmi du cuivre, de l'aluminium et de l'acier.

8.  Blindage électromagnétique selon l'une quelconque des revendications 2 à 7, **caractérisé en ce que** la tresse (1) possède au moins deux couches concentriques de fils (2) de section transversale ovale.

9.  Blindage électromagnétique selon l'une quelconque des revendications 1 à 8, **caractérisé en ce que** tous les fils (2) de la tresse (1) ont une section transversale ovale, et **en ce que** lesdits fils (2) sont disposés en spirale.

10. Blindage électromagnétique selon l'une quelconque des revendications 1 à 8, **caractérisé en ce que** tous les fils (2) de la tresse (1) ont une section transversale ovale, et **en ce que** lesdits fils sont torsadés entre eux.

**11.** Ensemble comprenant au moins un câble (3) et un blindage électromagnétique conforme à l'une quelconque des revendications 1 à 10, **caractérisé en ce que** la tresse (1) entoure ledit au moins un câble (3) en étant à son contact.

**12.** Ensemble selon la revendication 11, **caractérisé en ce qu'**il comprend au moins un câble électrique (3).

**Fig. 1**

**Fig. 2**

**Fig. 3A**

**Fig. 3B**

**Fig. 3C**

**Fig. 4A**

**Fig. 4B**

Europäisches
Patentamt

European
Patent Office

Office européen
des brevets

**RAPPORT DE RECHERCHE EUROPEENNE**

Numéro de la demande

EP 15 15 4744

| | DOCUMENTS CONSIDERES COMME PERTINENTS | | | |
|---|---|---|---|---|
| Catégorie | Citation du document avec indication, en cas de besoin, des parties pertinentes | | Revendication concernée | CLASSEMENT DE LA DEMANDE (IPC) |
| X | GB 1 207 117 A (FELTEN & GUILLEAUME CARLSWERK [DE]) 30 septembre 1970 (1970-09-30) * page 1, ligne 54 - ligne 77 * * page 2, ligne 4 - ligne 13 * * figures 1,2 * ----- | | 1-8,11, 12 | INV. H01B11/10 ADD. H01B11/18 H05K9/00 |
| X | US 6 384 337 B1 (DRUM MICHAEL K [US]) 7 mai 2002 (2002-05-07) * colonne 5, ligne 36 - ligne 51 * * figures 2-4 * ----- | | 1-8,11, 12 | |
| X | JP 2009 218037 A (FURUKAWA ELECTRIC CO LTD) 24 septembre 2009 (2009-09-24) * alinéa [0025] * * figures 1a, 1b, 2a, 3 * ----- | | 1,9,10 | |
| A | CH 220 575 A (LYNENWERK KG [DE]) 15 avril 1942 (1942-04-15) * page 1, ligne 18 - ligne 31 * * page 2, ligne 62 - ligne 92 * * figures 1-4 * ----- | | 1 | DOMAINES TECHNIQUES RECHERCHES (IPC) H01B H05K H02G |

Le présent rapport a été établi pour toutes les revendications

| Lieu de la recherche | Date d'achèvement de la recherche | Examinateur |
|---|---|---|
| La Haye | 21 juillet 2015 | Hillmayr, Heinrich |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.......................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**                    EP 15 15 4744

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-07-2015

| Document brevet cité au rapport de recherche | | | Date de publication | Membre(s) de la famille de brevet(s) | | | Date de publication |
|---|---|---|---|---|---|---|---|
| GB | 1207117 | A | 30-09-1970 | BE | 729737 | A | 18-08-1969 |
| | | | | CH | 482315 | A | 30-11-1969 |
| | | | | DE | 1765573 | A1 | 29-07-1971 |
| | | | | FR | 2010706 | A1 | 20-02-1970 |
| | | | | GB | 1207117 | A | 30-09-1970 |
| | | | | NL | 6907382 | A | 16-12-1969 |
| US | 6384337 | B1 | 07-05-2002 | AUCUN | | | |
| JP | 2009218037 | A | 24-09-2009 | JP | 5306673 | B2 | 02-10-2013 |
| | | | | JP | 2009218037 | A | 24-09-2009 |
| CH | 220575 | A | 15-04-1942 | BE | 442288 | A | 21-07-2015 |
| | | | | BE | 445934 | A | 21-07-2015 |
| | | | | CH | 220575 | A | 15-04-1942 |
| | | | | CH | 224725 | A | 15-12-1942 |
| | | | | CH | 225172 | A | 15-01-1943 |
| | | | | CH | 226131 | A | 15-03-1943 |
| | | | | CH | 226946 | A | 15-05-1943 |
| | | | | FR | 873673 | A | 16-07-1942 |
| | | | | FR | 882174 | A | 20-05-1943 |

EPO FORM P0460

Pour tout renseignement concernant cette annexe : voir Journal Officiel de l'Office européen des brevets, No.12/82